# EUROPÄISCHE PATENTSCHRIFT

(11) **EP 3 921 608 B1**
(45) Veröffentlichungstag und Bekanntmachung des Hinweises auf die Patenterteilung: **18.01.2023**
(21) Anmeldenummer: 20704454.6
(22) Anmeldetag: 04.02.2020
(51) Int. Cl.: G01G 21/28, G01G 23/48

(54) **GRAVIMETRISCHES MESSSYSTEM**
GRAVIMETRIC MEASURING SYSTEM
SYSTÈME DE MESURE GRAVIMÉTRIQUE

(30) Priorität: 05.02.2019 DE 102019102811
(43) Veröffentlichungstag der Anmeldung: 15.12.2021
(73) Patentinhaber: Sartorius Lab Instruments GmbH & Co. KG, 37079 Göttingen (DE)
(72) Erfinder: STÄNDER, Malte, 37308 Heiligenstadt (DE); HOLST, Heyko, 37085 Göttingen (DE)
(74) Vertreter: Novagraaf International SA
(86) Internationale Anmeldenummer: PCT/EP2020/052677
(87) Internationale Veröffentlichungsnummer: WO 2020/161102

(56) Entgegenhaltungen:
- DE-A1-102014 101 558
- DE-B4-102009 055 622
- JP-A- H0 228 522

## Beschreibung

### Gebiet der Erfindung

Die Erfindung betrifft ein gravimetrisches Messsystem, umfassend
- eine Waage mit einem von einer Wägeraumwandung umgebenen Wägeraum, einem elektromechanischen Wägesystem, einer elektronischen Steuereinrichtung zur Steuerung des Systembetriebs und einer von der Steuereinrichtung steuerbaren Kühlvorrichtung zur Kühlung des Wägeraums, sowie
- eine Mehrzahl von bei Betrieb Wärme generierenden Funktionsmodulen, die bedarfsweise in an der Wägeraumwandung angeordnete Modulaufnahmen einsetzbar sind.

### Stand der Technik

Derartige gravimetrische Messsysteme sind bekannt aus der EP 1 195 584 A1.

Analyse- und Laborwaagen, insbesondere solche, die auf dem Prinzip der elektromagnetischen Kompensation arbeiten, sind allgemein bekannt. Ein elektromechanisches Wägesystem, z.B. ein DMS- (Dehnmessstreifen) oder EMK-(elektromagnetische Kompensation) System, ist dabei in einem Wägesystemraum angeordnet, der eine möglichst gute Abschirmung gegenüber Umgebungseinflüssen gewähren soll. Ein mit der Lastaufnahme verbundener Träger ragt in einen üblicherweise benachbarten Wägeraum hinein, der ebenfalls, nämlich durch seine Wägeraumwandung, weitgehend von der Umgebung abgeschirmt ist. Die Wägeraumwandung setzt sich üblicherweise aus dem Wägeraumboden, den Wägeraumdeckel, Wägeraumseitenwänden sowie eine Vorder- und Rückwand zusammen. Die Rückwand kann häufig mit einer Wand des Wägesystemraums zusammenfallen. Eine oder beide Seitenwände des Wägeraums sind häufig als bewegbare Windschutz-Elemente ausgebildet. Auch der Deckel und/oder die Vorderseite können, in der Regel verschließbare, Zugangsöffnungen enthalten. Die Kopplung des Trägers zur Lastaufnahme des Wägesystems durchsetzt üblicherweise die Rückwand oder den Boden des Wägeraums.

Weiter enthalten derartige Waagen stets eine Steuereinrichtung, die insbesondere die Wägesensorik ansteuert und dabei speziell die Tauchspulenanordnung des Wägesystems regelt. Allerdings können die Steuereinrichtungen moderner Waagen deutlich komplexer ausgestaltet sein und insbesondere verschiedene Betriebsvarianten des Systembetriebs zur Verfügung stellen. Solche Betriebsvarianten können die Steuerung der Sensorik oder einer Kühlvorrichtung betreffen, sie können sich jedoch alternativ oder zusätzlich auf die Ansteuerung bestimmter Hilfseinrichtungen im oder am Wägeraum beziehen. Rein beispielhaft seien eine Kühlvorrichtung, eine Windschutzsteuerung, Hebevorrichtungen innerhalb des Wägeraums, Beleuchtungseinrichtungen und ähnliches genannt.

Aus der eingangs genannten, gattungsbildenden Druckschrift ist es bekannt, solche Hilfseinrichtungen mit Wägefunktionsbezug in Form von Modulen, d. h. als wägefunktionsbezogene Module, kurz Funktionsmodule, vorzuhalten und im Wägeraum, insbesondere an dessen Rückwand, eine schienenartige Haltevorrichtung vorzusehen, welche unterschiedliche mechanische Schnittstellen aufweist, an welchen im konkreten Einzelfall benötigte Funktionsmodule in der jeweils benötigten Position festgelegt werden können. Mit anderen Worten sind besagte Funktionsmodule bedarfsweise in entsprechende Modulaufnahmen an der Wägeraumwandung einsetzbar. Ein solch modulares System ist insbesondere in Laborumgebungen vorteilhaft, in denen mit ein und derselben Waage unterschiedliche Wägeaufgaben durchgeführt werden müssen. Die Waage kann dann vom Benutzer selbst entsprechend seinem konkreten Bedarf im Einzelfall konfektioniert werden. Selbst in Fällen, in denen die mechanischen Schnittstellen so gestaltet sind, dass ein Modulaustausch durch den Benutzer unmöglich ist, sind solch modulare Systeme auch herstellerseitig vorteilhaft. Aufbauend auf demselben Waagengrundkörper können durch Wahl der in die Modulaufnahmen eingesetzten Funktionsmodule Waagen für unterschiedliche Wägeaufgaben vorkonfektioniert werden. Die Anzahl herzustellender Spezialteile verringert sich drastisch, was zu einer deutlichen Kosteneinsparung führt.

Problematisch bei dem geschilderten Konzept ist der Umstand, dass im Fall aktiver Module, wie bspw. einer Beleuchtung, eines motorischen Moduls, eines Ionisators oder Ähnlichem durch unterschiedliche Module eine unterschiedliche Wärmeleistung eingebracht wird. Wägevorgänge sind jedoch bekanntermaßen äußerst temperaturkritisch. Typischerweise wird angestrebt, die Temperatur des gesamten Wägeraums der Umgebungstemperatur exakt anzupassen. Es sind allerdings auch Konzepte bekannt, in denen im Wägeraum ein bestimmter Temperaturgradient aufgebaut werden soll. Beispielhaft sei hierzu die DE 10 2009 055 622 B4 angegeben. In jedem Fall ist die erzielte Temperaturverteilung bei den bekannten Vorrichtung stets das Ergebnis einer sowohl räumlich als auch im Hinblick die thermische Leistung sehr genauen Abstimmung von installierten Wärmequellen und kompensierenden Kühlmaßnahmen. Jede Änderung der speziellen Anordnung von Wärmequellen, wie sie sich zwangsweise bei der bedarfsweisen, wechselnden Anforderungen angepassten Bestückung des Wägeraums mit unterschiedlichen Funktionsmodulen ergibt, wirkt sich störend auf die Temperaturverteilung im Wägeraum und daher nachteilig auf die Wägegenauigkeit aus.

Die nachveröffentlichte EP 3 557 199 A1 offenbart eine Waage mit einer aus mehreren Wandelementen zusammensetzbaren Wägeraum-Rückwand, deren Höhe auf diese Weise an unterschiedliche Windschutz-Höhen anpassbar ist, mithin Wägeräume unterschiedlicher Höhen aufbaubar sind.

Die EP 1 312 902 A1 offenbart eine Waage, an deren Wägeraum-Rückwand eine elektronische Zusatzeinheit, in welcher Versorgungseinheiten, bspw. eine Batterie, oder auch eine Steuerungselektronik angeordnet sein können, mithin ein Funktionsmodul im hiesigen Sinne, anbringbar ist. Die Druckschrift enthält keinerlei Hinweis auf die damit verbundene Problematik eines Wärmeeintrags in den Wägeraum.

Die EP 1 396 711 B1 offenbart eine Waage mit einem ohne jegliche Funktionsmodule ausgestatteten Wägeraum, die eine über ein thermoelektrisches Element vermittelte Wärmeabfuhr der Wägeelektronik und aus dem Wägeraum aufweist, wobei die spezielle thermische Ankopplung an die Wägeraum-Rückwand für die Ausbildung eines Temperaturgradienten innerhalb des Wägeraums sorgt.

Die DE 10 2014 101 561 A1 offenbart eine gravimetrische Dosiervorrichtung mit einem im Wägeraum angeordneten Klimamessmodul. Auf Basis der damit ermittelten Klimadaten können im Rahmen des Dosiervorgangs zu mischende Komponenten außerhalb der Vorrichtung vortemperiert werden.

Die DE 10 2009 055 624 A1 offenbart eine Waage mit einer in einem Gehäuseunterbau angeordneten Wägeelektronik, die mittels eines thermischen Abschirmblechs gegen insbesondere den Wägeraum abgeschirmt ist, wobei das Abschirmblech mit der kühlenden Seite eines thermoelektrischen Moduls verbunden ist.

Ein ähnlicher Ansatz wird in der JP 2 586 115 B2 verfolgt, wobei sich die thermisch abgeschirmte Wägeelektronik hier in einem Gehäuse hinter dem Wägeraum befindet.

### Aufgabenstellung

Es ist die Aufgabe der vorliegenden Erfindung, ein gattungsgemäßes gravimetrisches Messsystem derart weiterzubilden, dass eine bedarfsweise wechselnde Bestückung des Wägeraums mit Funktionsmodulen keine oder zumindest nur wesentlich verringerte Störungen der Temperaturverteilung im Wägeraum mit sich bringt.

### Darlegung der Erfindung

Diese Aufgabe wird in Verbindung mit den Merkmalen des Oberbegriffs von Anspruch 1 dadurch gelöst, dass die Modulaufnahmen thermisch mit der Kühlvorrichtung verbundene, geräteseitige Thermo-Schnittstellenkomponenten aufweisen und die Funktionsmodule korrespondierende, modulseitige Thermo-Schnittstellenkomponenten aufweisen, welche im eingesetzten Zustand des jeweiligen Funktionsmoduls die geräteseitige Thermo-Schnittstellenkomponente der jeweils zugeordneten Modulaufnahme thermisch kontaktieren.

Bevorzugte Ausführungsformen sind Gegenstand der abhängigen Ansprüche.

Die Erfindung sieht einen automatischen Anschluss der Funktionsmodule, d. h. der wechselnden Wärmequellen, an eine zentrale Kühlvorrichtung der Waage vor. Alle Modulaufnahmen, d. h. alle Positionen, an denen aktive, d. h. wärmegenerierende Funktionsmodule installiert werden können, sind mit geräteseitigen Thermo-Schnittstellenkomponenten bestückt, die allerdings lediglich im Bedarfsfall Einsatz finden, d. h. wenn tatsächlich ein Funktionsmodul mit korrespondierenden, modulseitigen Thermo-Schnittstellenkomponenten installiert wird. In Fällen, in denen kein Funktionsmodul in einer gegebenen Modulaufnahme installiert wird, bleibt die geräteseitige Thermo-Schnittstellenkomponente ohne Partner, d. h. unkontaktiert. Eine solche, nicht von einem aktiven Funktionsmodul besetzte Modulaufnahme kann mit einer Blende oder einem passiven, d. h. nicht wärmegenerierenden Funktionsmodul verschlossen werden. Dabei kann eine solche Blende bzw. ein solches passives Funktionsmodul gegebenenfalls mit geeigneten thermischen Isolationslementen ausgestattet sein, sodass die unkontaktierte geräteseitige Thermo-Schnittstellenkomponente keine die Temperaturverteilung im Wägeraum störende Kältequelle darstellt. Alternativ kann vorgesehen sein, dass die thermische Gesamtauslegung der Waage unter Berücksichtigung derartiger Kältequellen erfolgt, d. h. dass sich die gewünschte Temperaturverteilung im Wägeraum gerade bei unkontaktierten geräteseitigen Thermo-Schnittstellenkomponenten, also ohne installierte aktive Funktionsmodule, einstellt.

Bei Installation eines aktiven Funktionsmoduls erfolgt automatisch eine Kontaktierung der wechselseitigen Thermo-Schnittstellenkomponenten, sodass die Kühlvorrichtung die im Funktionsmodul generierte Wärme kompensierend abziehen kann. Eine solche Thermo-Schnittstelle kann beispielsweise in Form zweier, vorzugsweise gegeneinander federbelasteter, Metallplatten realisiert sein, von denen die eine thermisch an die Kühlvorrichtung und die andere thermisch an die Wärmequelle des Funktionsmoduls angeschlossen ist. Diese Platten sind relativ zueinander an der Waage, insbesondere im Bereich der Modulaufnahme, bzw. an dem Funktionsmodul derart positioniert, dass sie beim Einsetzen des Funktionsmoduls in die Modulaufnahme miteinander in, vorzugsweise federbelasteten, Kontakt kommen.

Praktisch besonders vorteilhaft ist es, wenn die Modulaufnahmen derart standardisiert sind, dass jede Modulaufnahme grundsätzlich zur Installation jedes Funktionsmoduls in der Lage ist. Hierdurch wird die Flexibilität beim Aufbau des gravimetrischen Messsystems maximiert. Problematisch kann dabei allerdings sein, dass unterschiedliche aktive Funktionsmodule unterschiedliche Wärmeleistungen erbringen. Dem könnte grundsätzlich mit individuellen Kühlvorrichtungen für jede Modulaufnahme begegnet werden. Dies erfordert jedoch einen konstruktiv und steuertechnisch sehr komplexen Aufbau der Kühlvorrichtung. Günstiger ist es, wenn sämtliche geräteseitigen Thermo-Schnittstellenkomponenten gemeinsam mit der Kühlvorrichtung, d. h. auch untereinander thermisch verbunden sind. Dies führt jedoch dazu, dass an allen geräteseitigen Thermo-Schnittstellenkomponenten dieselbe Kühlleistung anliegt, die unter Umständen nicht in optimaler Weise der Wärmeleistung des jeweils installierten Funktionsmoduls entspricht. Entsprechend könnte es dazu kommen, dass die Wärmeleistungen bestimmter Funktionsmodule über- und die anderer Funktionsmodule unterkompensiert werden. Dies stellt zwar noch immer eine erhebliche Verbesserung gegenüber bekannten gravimetrischen Messsystemen dar; gleichwohl wäre eine individuelle Kompensation wünschenswert.

Zu diesem Zweck ist bei einer Weiterbildung der Erfindung vorgesehen, dass jede geräteseitige Thermo-Schnittstellenkomponente eine geräteseitige Kontaktierungsfläche aufweist und die geräteseitigen Kontaktierungsflächen untereinander gleich groß sind und dass jede modulseitige Thermo-Schnittstellenkomponente eine modulseitige Kontaktierungsfläche aufweist und die modulseitigen Kontaktierungsflächen modulspezifisch unterschiedlich groß sind. Dabei kann insbesondere vorgesehen sein, dass die Größe jeder modulseitigen Kontaktierungsfläche gleich der oder kleiner als die Größe der geräteseitigen Kontaktierungsflächen und von der mittleren Betriebswärmeleistung des jeweiligen Funktionsmoduls abhängig ist. Mit anderen Worten ist bei dieser Weiterbildung also eine maximale Standardgröße der geräteseitigen Kontaktierungsflächen vorgesehen, wohingegen die modulseitigen Thermo-Schnittstellenkomponenten in der Regel kleiner und jedenfalls auf die Wärmeleistung ihrer Funktionsmodule abgestimmt sind. Dadurch wird nämlich von der Gesamtkühlleistung der Kühlvorrichtung, die ja aufgrund der gemeinsamen Kopplung und gleichen Ausgestaltung der geräteseitigen Kontaktflächen an den geräteseitigen Thermo-Schnittstellenkomponenten gleich verteilt anliegt, durch jedes Funktionsmodul nur ein solcher Bruchteil abgegriffen, wie er dem von dem jeweiligen Modul erzeugten Bruchteil an der Gesamtwärmeleistung entspricht. Module mit höherer Wärmeleistung erfahren also eine stärkere Kühlung; Module mit geringerer Wärmeleistung erfahren eine schwächere Kühlung. Man beachte, dass die Kontaktierungsflächen nicht zwangsläufig als jeweils zusammenhängende Flächen ausgestaltet sein müssen. Denkbar ist auch eine Ausgestaltung als eine Mehrzahl von Einzelflächen, insbesondere von Einzelflächen identischer Größen, von denen je nach Wärmeleistung des Moduls eine geeignete Mehrzahl thermisch kontaktiert bzw. nicht kontaktiert wird.

Die vorgenannte Weiterbildung sorgt also für eine relativ ausgewogenere Kühlung der unterschiedlichen, installierten Funktionsmodule. Eine absolute, exakte Kompensation der in jedem Funktionsmodul erzeugten Wärmeleistung ist hierdurch jedoch noch nicht zwingend gewährleistet. Diese ergibt sich aber, wenn die an den geräteseitigen Thermo-Schnittstellenkomponenten insgesamt anliegende Kühlleistung absolut der insgesamt von den installierten Funktionsmodulen erzeugten Wärmeleistung entspricht. Dies ist daher bei einer Weiterbildung der Erfindung auch so vorgesehen. Insbesondere ist vorgesehen, dass die Steuereinrichtung eingerichtet ist, die Kühlvorrichtung mit einer von der Art und Anzahl der eingesetzten Funktionsmodule abhängigen Kühlleistung anzusteuern. Dies setzt, wie der Fachmann erkennen wird, die Kenntnis der installierten Funktionsmodule in der Steuereinrichtung voraus. Wie weiter oben bereits erwähnt, kann dies durch geeignete Identifikations-Schnittstellen, die mechanisch, elektrisch, elektronisch, optisch, magnetisch, funktechnisch oder auf andere Weise realisiert sein können, gewährleistet werden. Herstellerseitig sind nämlich die von den einzelnen Funktionsmodulen erzeugten Wärmeleistungen sehr genau bekannt. Die Steuereinrichtung kann entsprechend programmiert werden, für jedes zusätzlich installierte Funktionsmodul die Kühlleistung um einen dessen Wärmeleistung entsprechenden Betrag zu erhöhen. Mit dieser Maßnahme wird also sichergestellt, dass die insgesamt an den geräteseitigen Thermo-Schnittstellenkomponenten anliegende Kühlleistung der von den installierten Funktionsmodulen insgesamt erzeugten Wärmeleistung entspricht.

Weiter ist bevorzugt vorgesehen, dass die Größen der modulseitigen Kontaktflächen derart aufeinander abgestimmt sind, dass jedes Funktionsmodul von der sich auf alle geräteseitigen Thermo-Schnittstellenkomponenten gleich verteilenden Kühlleistung den seine mittlere Betriebswärmeleistung kompensierenden Kühlleistungsbetrag abgreift. Dies kann insbesondere dadurch realisiert werden, dass die Größen der modulseitigen Kontaktflächen linear von der mittleren Betriebswärmeleistung des jeweiligen Funktionsmoduls abhängig sind. Beispielsweise kann die modulseitige Kontaktfläche eines Funktionsmoduls, welches die doppelte Wärmeleistung eines Referenzmoduls erzeugt, doppelt so groß sein wie die modulseitige Kontaktfläche des Referenzmoduls.

Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: eine schematische Darstellung eines erfindungsgemäßen gravimetrischen Messsystems im Montageendzustand mit unvollständig dargestellter Wägeraumwandung,
- Figur 2:: die Wägeraumrückwand der Waage des gravimetrischen Messsystems von Figur 1 in einem Montagezwischenzustand ohne eingesetzte Funktionsmodule oder Blenden,
- Figur 3:: eine unvollständige Schnittdarstellung der Wägeraumrückwand der Waage des gravimetrischen Messsystems von Figur 1 und daran angrenzender Bereiche sowie
- Figur 4:: eine schematische Darstellung einer bevorzugten Kühlungssteuerung der Waage des gravimetrischen Messsystems von Figur 1.

### Beschreibung bevorzugter Ausführungsformen

Gleiche Bezugszeichen in den Figuren deuten auf gleiche oder analoge Elemente hin.

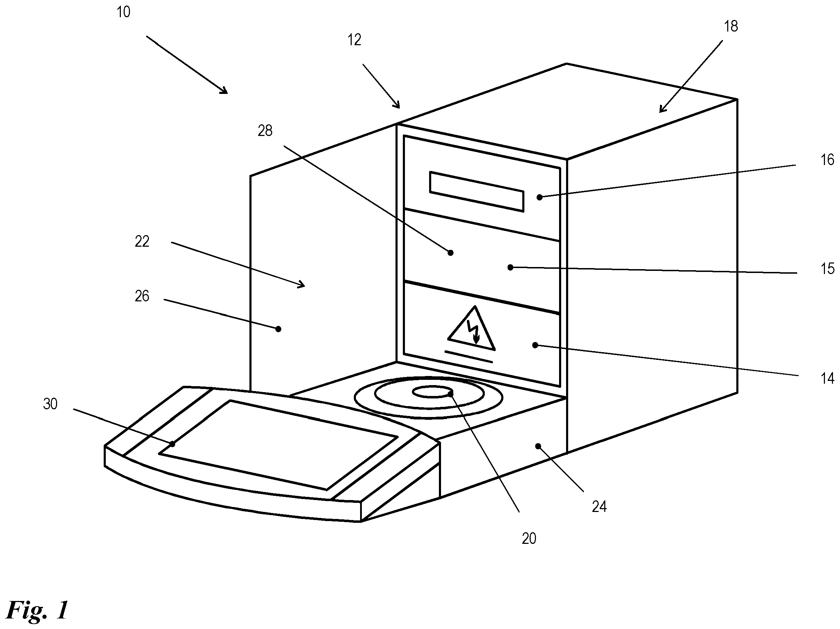

Figur 1 zeigt eine schematische Darstellung eines erfindungsgemäßen gravimetrischen Messsystems 10, welches im Wesentlichen aus einer Waage 12 und zwei darin eingesetzten Funktionsmodulen 14, 16 sowie einer Blende 15 besteht. Bei der gezeigten Ausführungsform ist das mit dem Bezugszeichen 14 versehene Funktionsmodul eine zur Erkennung von Barcodes geeignete Laserscannereinheit und das mit dem Bezugszeichen 16 versehene Funktionsmodul eine Beleuchtungseinheit. Die konkreten Funktionen der Funktionsmodule 14, 16 spielen im Kontext der vorliegenden Erfindung jedoch keine Rolle.

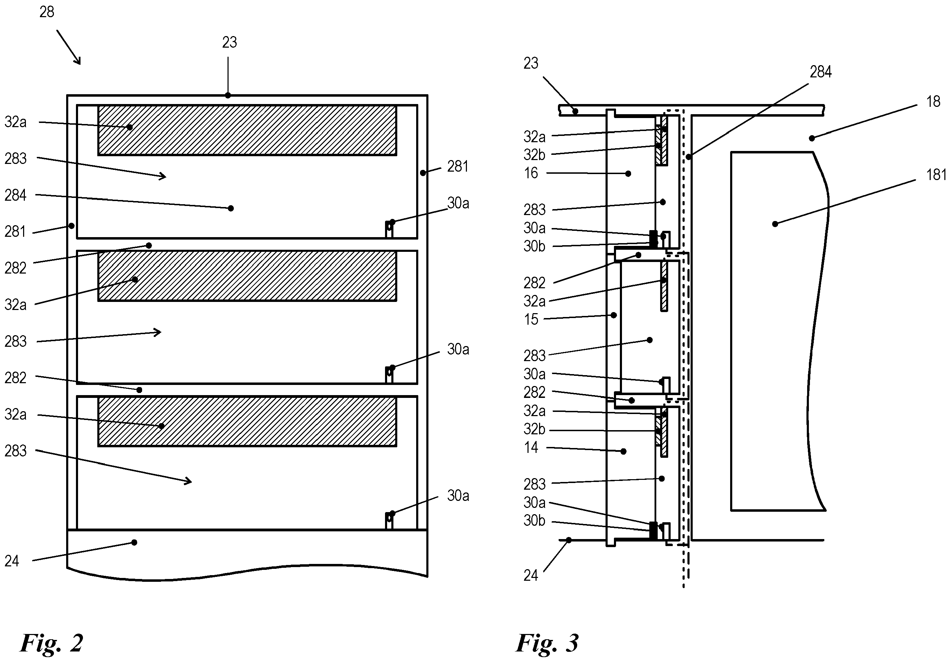

Die Waage 12 umfasst bei der gezeigten Ausführungsform im Wesentlichen drei Bereiche, nämlich einen Wägesystemraum 18, in dem ein in Figur 3 angedeutetes Wägesystem 181 angeordnet ist. Der konkrete Aufbau des Wägesystems 181 spielt im Kontext der vorliegenden Erfindung keine Rolle. Das Wägesystem 181 umfasst in jedem Fall eine nicht gesondert dargestellte Lastaufnahme, die mit einem Wägegutträger 20 verbunden ist, welcher seinerseits in einem bei der dargestellten Ausführungsform an den Wägesystemraum 18 angrenzenden Wägeraum 22 angeordnet ist. Der Wägeraum 22 ist von einer Wägeraumwandung umgeben, die in Figur 1 nur unvollständig dargestellt ist. Insbesondere sind der von dem Wägegutträger 20 durchsetzte Wägeraumboden 24, eine Wägeraumseitenwand 26 sowie eine Wägeraumrückwand 28, auf die weiter unten noch näher einzugehen sein wird, dargestellt. Die Wägeraumrückwand 28 ist bei der Darstellung von Figur 1 im Wesentlichen durch die Frontseiten der Funktionsmodule 14, 16 sowie die zwischen diesen Funktionsmodulen 14, 16 angeordnete Blende 15 verdeckt. Typischerweise umfasst die Wägeraumwandung zusätzlich eine weitere Wägeraumseitenwand, eine Wägeraumvorderwand und einen (nur in den Figuren 2 und 3 angedeuteten) Wägeraumdeckel 23, die aus Gründen der besseren Übersichtlichkeit in Figur 1 jedoch nicht dargestellt sind.

Weiter umfasst die Waage 12 eine Elektronikeinheit 30, die bei der gezeigten Ausführungsform im Wesentlichen eine großformatige Anzeige umfasst. Die Elektronikeinheit 30 kann zusätzlich eine Steuereinrichtung enthalten, auf die weiter unten noch näher einzugehen sein wird. Diese Steuereinrichtung kann jedoch auch an anderer Stelle der Waage 12 angeordnet sein. Als günstig wird angesehen, wenn diese Steuereinheit thermisch isoliert vom Wägesystemraum 18 sowie vom Wägeraum 22 angeordnet ist.

Figur 2 zeigt eine Frontalansicht der Wägeraumrückwand 28, allerdings ohne die eingesetzten Funktionsmodule 14, 16 und ohne die Blende 15. Figur 3 zeigt eine Schnittansicht der Wägeraumrückwand 28 und angrenzender Bereiche der Waage 12, wobei die Darstellung von Figur 3 allerdings auch die eingesetzten Funktionsmodule 14, 16, sowie die eingesetzte Blende 15 zeigt. Trotz dieses Unterschiedes erleichtert eine Zusammenschau der Figuren 2 und 3 das Verständnis der nachfolgenden Beschreibung.

Die Wägeraumrückwand 28 ist aus senkrechten Pfosten 281 und quer dazu angeordneten Streben 282 aufgebaut. Zwischen diesen erstrecken sich Ausnehmungen 283, die hier auch als Modulaufnahmen 283 bezeichnet werden. Wägesystemraumseitig weist die Wägeraumrückwand 28 eine den Wägesystemraum 18 versiegelnde Abschlusswand 284 auf, die einen Durchgriff durch die Modulaufnahmen 283 in den Wägesystemraum 18 verhindert. Bei der dargestellten Ausführungsform ist die Abschlusswand 284 zugleich die Vorderwand des Wägesystemraums 18.

Die Modulaufnahmen 283 dienen der räumlich angepassten Aufnahme der Funktionsmodule 14, 16. In die in den Figuren 2 und 3 mittlere Modulaufnahme 283 ist bei der Ausführungsform der Figuren 1 und 3 kein Funktionsmodul eingesetzt. Diese Ausnehmung 283 zwischen den Pfosten 281 und Streben 282 ist durch die Blende 15 zum Wägeraum hin verschlossen. Die Modulaufnahmen 283 sind hinsichtlich ihrer nachfolgend näher zu beschreibenden Ausstattung identisch ausgebildet, sodass die Funktionsmodule 14, 16 ebenso wie andere, kompatibel ausgebildete Funktionsmodule in jede der Modulaufnahmen 283 einsetzbar sind. Hinsichtlich ihrer Größe sind die Modulaufnahmen 283 bevorzugt identisch, besonders bevorzugt ohne Trennelement ineinander übergehend ausgebildet, sodass Funktionsmodule 14, 16, deren Größe einem ganzzahligen Vielfachen einer Einheitsgröße entspricht, exakt in eine oder in mehrere einander benachbarte Modulaufnahmen 283 passend eingesetzt werden können. Denkbar ist auch, dass die Größen der Modulaufnahmen 283 selbst unterschiedliche ganzzahlige Vielfache einer Einheitsgröße sind. Gleiches wie für die Funktionsmodule 14, 16 gilt selbstverständlich auch für die Blenden 15.

Jede Modulaufnahme 283 verfügt über eine geräteseitige Identifikations-schnittstellenkomponente 30a, die mit einer korrespondierenden, modulseitigen Identifikations-Schnittstellenkomponente 30b eines eingesetzten Funktionsmoduls 14, 16 wechselwirken kann, um das eingesetzte Funktionsmodul 14, 16 zu identifizieren und über eine entsprechende Datenleitung (gestrichelte Linien) mit einer Steuereinheit zu verbinden.

Weiter weist jede Modulaufnahme 283 eine geräteseitige Thermo-Schnittstellenkomponente 32a auf, die mit einer korrespondierenden, modulseitigen Thermo-Schnittstellenkomponente 32b eines eingesetzten Funktionsmoduls 14, 16 in thermischem Kontakt steht. Die geräteseitigen Thermo-Schnittstellenkomponenten 32b sind untereinander sowie mit einer nicht dargestellten Kühlvorrichtung thermisch verbunden (punktierte Linien).

Weitere Schnittstellen, wie beispielsweise elektrische und elektronische, insbesondere datentechnische Schnittstellen zur Ansteuerung der Funktionsmodule 14, 16 sind zwar vorzugsweise vorgesehen, in den Figuren der Übersichtlichkeit halber nicht dargestellt.

Eine Besonderheit der modulseitigen Thermo-Schnittstellenkomponenten 32b der gezeigten Ausführungsform liegt darin, dass sie im Vergleich zu den geräteseitigen Thermo-Schnittstellenkomponenten 32a sowie untereinander unterschiedliche Kontaktflächengrößen aufweisen. Sämtliche modulseitigen Thermo-Schnittstellenkomponenten 32b sind kleiner als oder höchstens genauso groß wie die untereinander gleich großen, geräteseitigen Thermo-Schnittstellenkomponenten 32a. Die spezielle Größe der modulseitigen Kontaktflächen hängt von der Wärmeleistung der jeweiligen Funktionsmodule 14, 16 ab. Insbesondere kann eine Proportionalität zwischen der Wärmeleistung und der thermischen Kontaktflächengröße der Module bestehen.

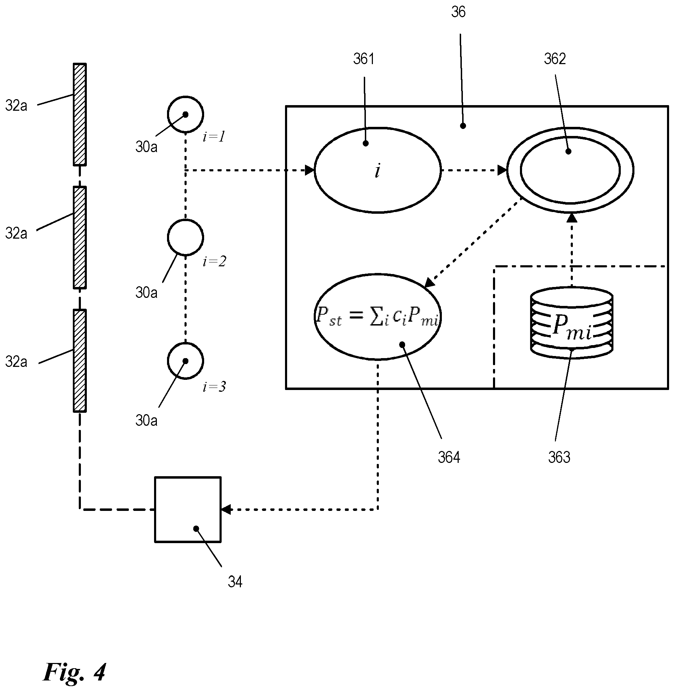

Figur 4 zeigt eine bevorzugte Ausführungsform einer Steuerung der Waage 12. Dargestellt sind die thermisch untereinander sowie mit einer Kühlvorrichtung 34 verbundenen, geräteseitigen Thermo-Schnittstellenkomponenten 32a sowie die geräteseitigen Identifikations-Schnittstellenkomponenten 30a, die hier jeweils mit dem Index i identifiziert sind. Die durch Wechselwirkung der geräteseitigen und modulseitigen Identifikations-Schnittstellenkomponenten 30a, b gewonnenen Identifikationsdaten, werden an eine Steuereinrichtung 36, dort insbesondere an die Identifikationseinheit 361 gesendet. Bei der in den Figuren 1 und 3 dargestellten Ausführungsform würde die Identifikations-Schnittstelle i=1 die Information über das eingesetzte Beleuchtungsmodul 16 liefern. Die Identifikations-Schnittstelle i=2 würde die Information über das Fehlen eines eingesetzten Funktionsmoduls liefern und die Identifikations-Schnittstelle i=3 würde die Information über das eingesetzte Laserscanner-Modul 14 liefern. Die Identifikation kann modultypspezifisch oder sogar modulindividuell erfolgen.

Die Identifikationsdaten werden von der Identifikationseinheit 361 an eine Zentraleinheit 362 gesendet. Diese erhält aus einer Speichereinheit 363 Informationen über die konkreten Wärmeleistungen der identifizierten Funktionsmodule 14, 16. Wie durch die strichpunktierte Linie angedeutet, kann die Speichereinheit 363 in die Steuereinrichtung 36 integriert oder entfernt davon, beispielsweise in einem über Internet angebundenen Server, vorgehalten sein. Allerdings kann diese Information auch in einer Speichereinheit des Funktionsmoduls selbst vorgehalten werden. Insbesondere kann vorgesehen sein, dass das Funktionsmodul nach seiner Fertigung werksseitig im Rahmen der Qualitätskontrolle eine individuelle Messung seiner Wärmeleistung durchläuft, deren Ergebnis dann in der Speichereinheit hinterlegt wird. Auch eine typenspezifische Hinterlegung ohne individuelle Messung ist möglich. In jedem Fall verbindet die Informationshinterlegung im Modul selbst die Vorteile der Entlastung der Waagen-Steuereinheit, der Unabhängigkeit von externen Datenquellen und der Möglichkeit der Individualisierung.

Aus den Identifikationsdaten einerseits und den Wärmeleistungsdaten andererseits berechnet die Zentraleinheit 362 die Vorgabewerte zur Ansteuerung der Kühlvorrichtung 34, die an eine mit der Kühlvorrichtung verbundene Kühlungssteuerungseinheit 364 weitergegeben werden. Bei der dargestellten Ausführungsform entspricht die vorgegebene Kühlleistung Pₛₜ einer statischen Kühlleistung, die sich aus der Summe der Einzelwärmeleistungen Pₘᵢ der identifizierten Funktionsmodule 14, 16, jeweils multipliziert mit einem Wichtungsfaktor Cᵢ, zusammensetzt: *Pₛₜ* = ∑*ᵢcᵢPₘᵢ.* Die Gesamtkühlleistung P ergibt sich in diesem Fall als Summe einer in Figur 4 nicht erwähnten, modulunabhängigen Grundkühlleistung Po und der modulabhängigen statischen Kühlleistung Pₛₜ: *P* = *P*₀ + *Pₛₜ* + *Pᵥ*

Mit dem Wichtungsfaktor cᵢ kann beispielsweise die spezielle Position, d.h. die spezielle Modulaufnahme, berücksichtigt werden, in der ein Funktionsmodul 14, 16 eingesetzt ist. Selbstverständlich kann auf eine solche Wichtung auch verzichtet werden, d.h. der Wichtungsfaktor entspricht dann 1 bzw. ist in allen Summanden identisch.

Diese statische Kühlleistung Pₛₜ wird von der Kühlvorrichtung 34 an sämtliche geräteseitigen Thermo-Schnittstellenkomponenten 32a gleich verteilt. Die jeweils bedarfsgerechte Verteilung an die Funktionsmodule 14, 16 erfolgt über die unterschiedlichen Größen der modulseitigen Thermo-Schnittstellenkomponenten 32b.

Bei einer Weiterbildung dieser Kühlungssteuerung bildet die statische Kühlleistung Pₛₜ nur einen von mehreren Termen der Gesamtkühlleistung P: *P* = *P*₀ + *Pₛₜ* + *Pᵥ* mit *Pᵥ* = *Pᵥ*(*T*)*.* Bei dieser Ausführungsform ist zusätzlich zur statischen Kühlleistung Pₛₜ noch ein geringer, geregelter Kühlleistungsbeitrag, die Korrekturkühlleistung Pᵥ vorgesehen, mit dem geringe Schwankungen der Temperatur T im Wägeraum 22 kompensiert werden können.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum von Variationsmöglichkeiten an die Hand gegeben. Insbesondere ist es möglich, alternativ oder zusätzlich zur Wägeraumrückwand 28 eine oder mehrere der übrigen Wände der Wägeraumwandung in der beschriebenen Weise als Pfosten/Streben-Struktur mit als Modulaufnahmen ausgebildeten Ausnehmungen zu gestalten. In solchen Fällen, in denen die Modulaufnahmen nicht an einen, insbesondere aus eichrechtlichen Gründen zu versiegelnden Raum grenzen, wird eine spezielle Versiegelungswand wie bei der hier gezeigten Ausführungsform nicht erforderlich sein.

### Bezugszeichenliste

- 10: gravimetrisches Messsystem
- 12: Waage
- 14: Funktionsmodul
- 15: Blende
- 16: Funktionsmodul
- 18: Wägesystemraum
- 181: Wägesystem
- 20: Wägegutträger
- 22: Wägeraum
- 23: Wägeraumdeckel
- 24: Wägeraumboden
- 26: Wägeraumseitenwand
- 28: Wägeraumrückwand
- 281: Pfosten
- 282: Strebe
- 283: Ausnehmung/Modulaufnahme
- 284: Abschlusswand
- 30a/b: geräteseitige/modulseitige Identifikations-Schnittstellenkomponente
- 32a/b: geräteseitige/modulseitige Thermo-Schnittstellenkomponente
- 34: Kühlvorrichtung
- 36: Steuereinrichtung
- 361: Identifikationseinheit
- 362: Zentraleinheit
- 363: Speichereinheit
- 364: Kühlungssteuerungseinheit
- P: Gesamtkühlleistung
- Po: Grundkühlleistung
- Pᵥ: Korrekturkühlleistung
- cᵢ: Wichtungsfaktor
- Pₘᵢ: modulspezifische Wärmeleistung
- T: Temperatur (im Wägeraum)

## Patentansprüche

1. Gravimetrisches Messsystem (10), umfassend
- eine Waage (12) mit einem von einer Wägeraumwandung (23, 24, 26, 28) umgebenen Wägeraum (22), einem elektromechanischen Wägesystem (181), einer elektronischen Steuereinrichtung (36) zur Steuerung des Systembetriebs, sowie
- eine Mehrzahl von bei Betrieb Wärme generierenden Funktionsmodulen (14, 16), die bedarfsweise in an der Wägeraumwandung (28) angeordnete Modulaufnahmen (283) einsetzbar sind,
**dadurch gekennzeichnet,**
**dass** die Waage (12) eine von der Steuereinrichtung steuerbare Kühlvorrichtung (34) zur Kühlung des Wägeraums (22) aufweist; und
**dass** die Modulaufnahmen (283) thermisch mit der Kühlvorrichtung (34) verbundene, geräteseitige Thermo-Schnittstellenkomponenten (32a) aufweisen und die Funktionsmodule (14, 16) korrespondierende, modulseitige Thermo-Schnittstellenkomponenten (32b) aufweisen, welche im eingesetzten Zustand des jeweiligen Funktionsmoduls (14, 16) die geräteseitige Thermo-Schnittstellenkomponente (32a) der jeweils zugeordneten Modulaufnahme (283) thermisch kontaktieren.

2. Gravimetrisches Messsystem (10) nach Anspruch 1,
**dadurch gekennzeichnet,**
**dass** jede geräteseitige Thermo-Schnittstellenkomponente (32a) eine geräteseitige Kontaktierungsfläche aufweist und die geräteseitigen Kontaktierungsflächen untereinander gleich groß sind
und **dass** jede modulseitige Thermo-Schnittstellenkomponente (32b) eine modulseitige Kontaktierungsflächen aufweist und die modulseitigen Kontaktierungsfläche modulspezifisch unterschiedlich groß sind,
wobei die Größe jeder modulseitigen Kontaktierungsfläche gleich der oder kleiner als die Größe der geräteseitigen Kontaktierungsflächen und von der mittleren Betriebswärmeleistung des jeweiligen Funktionsmoduls (14, 16) abhängig ist.

3. Gravimetrisches Messsystem (10) nach Anspruch 2,
**dadurch gekennzeichnet,**
**dass** die Steuereinrichtung (36) eingerichtet ist, die Kühlvorrichtung (34) mit einer von der Art und Anzahl der eingesetzten Funktionsmodule (14, 16) abhängigen Kühlleistung (P) anzusteuern.

4. Gravimetrisches Messsystem (10) nach Anspruch 3,
**dadurch gekennzeichnet,**
**dass** die Größen der modulseitigen Kontaktflächen derart aufeinander abgestimmt sind, dass jedes Funktionsmodul (14, 16) von der sich auf alle geräteseitigen Thermo-Schnittstellenkomponenten (32a) gleich verteilenden Kühlleistung (P) den seine mittlere Betriebswärmeleistung kompensierenden Kühlleistungsbetrag abgreift.

5. Gravimetrisches Messsystem (10) nach Anspruch 4,
**dadurch gekennzeichnet,**
**dass** die Größen der modulseitigen Kontaktflächen linear von der mittleren BetriebsWärmeleistung des jeweiligen Funktionsmoduls (14, 16) abhängig sind.

6. Gravimetrisches Messsystem (10) nach einem der Ansprüche 2 bis 5,
dass jede Modulaufnahme (283) eine geräteseitige Identifikationsschnittstellen-Komponente (30a) und jedes Funktionsmodul (14, 16) eine korrespondierende, modulseitige Identifikationsschnittstellen-Komponente (30b) aufweist und dass die Steuereinrichtung (36) eingerichtet ist, jedes in eine Modulaufnahme (283) eingesetzte Funktionsmodul (14, 16) durch Wechselwirkung zwischen der jeweiligen geräte- und modulseitigen Identifikationsschnittstellen-Komponenten (30a, b) zu identifizieren und die Kühlvorrichtung (34) entsprechend anzusteuern.

## Claims

1. A gravimetric measuring system (10), comprising
- a scale (12) having a weighing chamber (22) surrounded by a weighing chamber wall (23, 24, 26, 28), an electromechanical weighing system (181), an electronic control apparatus (36) for controlling the system operation, and
- a plurality of function modules (14, 16) generating heat during operation, which can be optionally inserted into module receptacles (283) arranged at the weighing chamber wall (28),
**characterized in**
**that** the scale (12) has a cooling device (34) controllable by the control apparatus for cooling the weighing chamber (22); and
**that** the module receptacles (283) have device-side thermal interface components (32a) thermally connected to the cooling device (34) and the function modules (14, 16) have corresponding module-side thermal interface components (32b) which in the inserted state of the respective function module (14, 16) thermally contact the device-side thermal interface component (32a) of the respectively assigned module receptacle (283).

2. The gravimetric system (10) according to claim 1, **characterized in**
**that** each device-side thermal interface component (32a) has a device-side contacting surface and the device-side contacting surfaces are identical in size to one another
and **that** each module-side thermal interface component (32b) has a module-side contacting surface and the module-side contacting surfaces are different in size depending on the module,
wherein the size of each module-side contacting surface is identical to or smaller than the size of the device-side contacting surfaces and is dependent on the average operating heat output of the respective function module (14, 16).

3. The gravimetric system (10) according to claim 2, **characterized in**
**that** the control apparatus (36) is set up to control the cooling device (34) with a cooling capacity (P) dependent on the type and number of inserted function modules (14, 16).

4. The gravimetric system (10) according to claim 3, **characterized in**
**that** the sizes of the module-side contact surfaces are coordinated to one another such that each function module (14, 16) taps the cooling capacity amount compensating its average operating heat output from the cooling capacity (P) being distributed equally to all device-side thermal interface components (32a).

5. The gravimetric system (10) according to claim 4, **characterized in**
**that** the sizes of the module-side contact surfaces are linearly dependent on the average operating heat output of the respective function module (14, 16).

6. The gravimetric system (10) according to any of claims 2 to 5,
**characterized in that** each module receptacle (283) has a device-side identification interface component (30a) and each function module (14, 16) has a corresponding module-side identification interface component (30b)
and that the control apparatus (36) is set up to identify each function module (14, 16) inserted into a module receptacle (283) by interacting between the respective device-side and module-side identification interface components (30a, b) and to correspondingly control the cooling device (34).

## Revendications

1. Système de mesure gravimétrique (10), comprenant
- une balance (12) avec un espace de pesée (22) entouré par une paroi d'espace de pesée (23, 24, 26, 28), un système de pesée électromécanique (181), un équipement de commande électronique (36) pour la commande du fonctionnement de système, ainsi que
- une pluralité de modules fonctionnels (14, 16) générant de la chaleur lors du fonctionnement, qui peuvent être utilisés si besoin est dans des logements de module (283) disposés sur la paroi d'espace de pesée (28),
**caractérisé en ce**
**que** la balance (12) présente un dispositif de refroidissement (34) pouvant être commandé par l'équipement de commande pour le refroidissement de l'espace de pesée (22) ; et
**que** les logements de module (283) présentent des composants d'interface thermique côté appareil (32a), reliés thermiquement au dispositif de refroidissement (34) et les modules fonctionnels (14, 16) présentent des composants d'interface thermique côté module (32b) correspondants, lesquels dans l'état inséré du module fonctionnel (14, 16) respectif sont en contact thermique avec le composant d'interface thermique côté appareil (32a) du logement de module (283) respectivement associé.

2. Système de mesure gravimétrique (10) selon la revendication 1,
**caractérisé en ce**
**que** chaque composant d'interface thermique côté appareil (32a) présente une surface de mise en contact côté appareil et les surfaces de mise en contact côté appareil sont mutuellement de même dimension
et **que** chaque composant d'interface thermique côté module (32b) présente une surface de mise en contact côté module et les surfaces de mise en contact côté module sont mutuellement de même dimension de manière spécifique au module,
dans lequel la dimension de chaque surface de mise en contact côté module est inférieure ou égale à la dimension des surfaces de mise en contact côté appareil et dépend de la puissance calorifique de fonctionnement moyenne du module fonctionnel (14, 16) respectif.

3. Système de mesure gravimétrique (10) selon la revendication 2,
**caractérisé en ce**
**que** l'équipement de commande (36) est conçu pour commander le dispositif de refroidissement (34) avec une puissance frigorifique (P) dépendant du type et nombre des modules fonctionnels (14, 16) utilisés.

4. Système de mesure gravimétrique (10) selon la revendication 3,
**caractérisé en ce**
**que** les dimensions des surfaces de contact côté module sont adaptées les unes aux autres de telle sorte que chaque module fonctionnel (14, 16) prélève de la puissance frigorifique (P) se répartissant de la même façon sur tous les composants d'interface thermique côté appareil (32a) la valeur de puissance frigorifique compensant sa puissance calorifique de fonctionnement moyenne.

5. Système de mesure gravimétrique (10) selon la revendication 4,
**caractérisé en ce**
**que** les dimensions des surfaces de contact côté module dépendent linéairement de la puissance calorifique de fonctionnement moyenne du module fonctionnel (14, 16) respectif.

6. Système de mesure gravimétrique (10) selon l'une quelconque des revendications 2 à 5,
**caractérisé en ce que** chaque logement de module (283) présente un composant d'interface d'identification côté appareil (30a) et chaque module fonctionnel (14, 16) un composant d'interface d'identification côté module (30b) correspondant
et que l'équipement de commande (36) est conçu pour identifier chaque module fonctionnel (14, 16) utilisé dans un logement de module (283) par interaction entre les composants d'interface d'identification côté appareil et module (30a, b) respectifs et pour commander de manière correspondante le dispositif de refroidissement (34).
